# EUROPEAN PATENT APPLICATION

(11) **EP 4 328 208 A1**
(43) Date of publication of application: **28.02.2024**
(21) Application number: 22791717.6
(22) Date of filing: 19.04.2022
(51) Int. Cl.: C04B 37/02, H01L 23/13, H05K 1/02

(54) **COPPER/CERAMIC BONDED BODY AND INSULATED CIRCUIT BOARD**

(30) Priority: 19.04.2021 JP 2021070220
(71) Applicant: Mitsubishi Materials Corporation, Tokyo 100-8117 (JP)
(72) Inventor: TERASAKI Nobuyuki, Saitama-shi, Saitama 330-8508 (JP)
(74) Representative: Hoffmann Eitle
(86) International application number: PCT/JP2022/018126
(87) International publication number: WO 2022/224946

(57) **Abstract**

In a copper/ceramic bonded body according to the present invention, copper members (12) and (13) are each bonded to one surface and the other surface of a ceramic member (11), active metal nitride layers (21) and (31) are formed on the ceramic member (11) side of the copper members (12) and (13), area rates A1 and A2 of an active metal compound containing Si and an active metal are set to 10% or less in regions (E1) and (E2) of 10 µm from the active metal nitride layers (21) and (31) to the copper members (12) and (13), and a ratio A1/A2 of the area rate A1 of the active metal compound on a side of the one surface and the area rate A2 of the active metal compound on a side of the other surface is set in a range of 0.7 or more and 1.4 or less.

## Description

### TECHNICAL FIELD

The present invention relates to a copper/ceramic bonded body obtained by bonding a copper member consisting of copper or a copper alloy to a ceramic member, and an insulating circuit substrate including a ceramic substrate and a copper sheet consisting of copper or a copper alloy, which is bonded to a surface of the ceramic substrate.

Priority is claimed on Japanese Patent Application No. 2021-070220, filed April 19, 2021, the content of which is incorporated herein by reference.

### BACKGROUND ART

A power module, an LED module, and a thermoelectric module have a structure in which a power semiconductor element, an LED element, and a thermoelectric element are bonded to an insulating circuit substrate in which a circuit layer consisting of a conductive material is formed on one surface of an insulating layer.

For example, a power semiconductor element for high power control, which is used for controlling wind power generation, an electric vehicle, a hybrid vehicle, or the like, generates a large amount of heat during operation, and thus, an insulating circuit substrate including a ceramic substrate, a circuit layer formed by bonding a metal plate having excellent electrical conductivity to one surface of the ceramic substrate, and a metal layer for heat radiation, which is formed by bonding a metal plate to the other surface of the ceramic substrate, has been widely used in the related art as a substrate on which the power semiconductor element is mounted.

For example, Patent Document 1 proposes an insulating circuit substrate in which a circuit layer and a metal layer are formed by bonding a copper sheet to one surface and the other surface of a ceramic substrate. In Patent Document 1, the copper sheet is disposed on the one surface and the other surface of the ceramic substrate with an Ag-Cu-Ti-based brazing material being interposed, and then a heat treatment is carried out to bond the copper sheet (so-called active metal brazing method).

In addition, Patent Document 2 proposes a power module substrate in which a copper sheet consisting of copper or a copper alloy is bonded to a ceramic substrate consisting of silicon nitride by using a bonding material containing Ag and Ti.

As described above, in a case of bonding a copper sheet to a ceramic substrate using a bonding material containing Ti, Ti, which is an active metal, reacts with the ceramic substrate, thereby improving the wettability of the bonding material, which improves the bonding strength between the copper sheet and the ceramic substrate.

### [Citation List]

### [Patent Documents]

[Patent Document 1]
   Japanese Patent No. 3211856 (B)
[Patent Document 2]
   Japanese Unexamined Patent Application, First Publication No. 2018-008869 (A)

### SUMMARY OF INVENTION

### Technical Problem

In recent years, there has been a tendency for a heat generation temperature of a semiconductor element mounted on an insulating circuit substrate to increase, and an insulating circuit substrate is required to have thermal cycle reliability that can withstand a thermal cycle more severe than a thermal cycle in the related art.

Here, in a case of bonding a copper sheet to a ceramic substrate using a bonding material containing Ti, as described above, there is a risk that Ti, which is an active metal, diffuses to the copper sheet side, and an intermetallic compound containing Cu and Ti precipitates, whereby the vicinity of the bonded interface becomes hard, the ceramic member is likely to be easily broken during loading of a thermal cycle, and the thermal cycle reliability deteriorates.

The present invention has been made in consideration of the above-described circumstances, and an objective of the present invention is to provide a copper/ceramic bonded body having excellent thermal cycle reliability which can suppress the occurrence of breakage in a ceramic member even in a case where a severe thermal cycle is loaded, and an insulating circuit substrate consisting of the copper/ceramic bonded body.

### Solution to Problem

As a result of diligent studies by the inventors of the present invention in order to solve the above-described problems, it was found that the structure is different at the bonded interface between the ceramic member and the copper sheet bonded to one surface of the ceramic member and at the bonded interface between the ceramic member and the copper sheet bonded to the other surface of the ceramic member depending on the shape of the copper member to be bonded to each of one surface and the other surface of the ceramic member, the coating of the bonding material, the occurrence of a liquid phase at the time of bonding, and the like.

In addition, it was found that in a case where the hardness of the bonded interface between the ceramic member and the copper member bonded to each of one surface and the other surface of the ceramic member is different, the balance of thermal stress applied to the ceramic member during loading of a thermal cycle is lost, and the ceramic member is likely to be easily broken.

The present invention has been made based on the above-described findings, and the copper/ceramic bonded body according to the present invention is characterized by being a copper/ceramic bonded body including a copper member consisting of copper or a copper alloy and a ceramic member consisting of silicon nitride, which is bonded to the copper member, in which the copper member is bonded to each of one surface and the other surface of the ceramic member, an active metal nitride layer is formed on a side of the ceramic member of the copper member, where in a region of 10 µm from the active metal nitride layer to a side of the copper member, an area rate of an active metal compound containing Si and an active metal is set to 10% or less, and a ratio A1/A2 of an area rate A1 of the active metal compound in the copper member bonded to a side of the one surface to an area rate A2 of the active metal compound in the copper member bonded to a side of the other surface is set in a range of 0.7 or more and 1.4 or less.

According to the copper/ceramic bonded body according to the present invention, at the bonded interface between the ceramic member and the copper member bonded to each of one surface and the other surface of the ceramic member, an area rate of an active metal compound containing Si and an active metal is set to 10% or less in a region of 10 µm from the active metal nitride layer to a side of the copper member, which suppresses the unnecessary hardening of the bonded interface between the ceramic member and the copper member.

In addition, since a ratio A1/A2 of an area rate A1 of the active metal compound in the copper member bonded to a side of the one surface to an area rate A2 of the active metal compound in the copper member bonded to a side of the other surface is set in a range of 0.7 or more and 1.4 or less, there is no significant difference in the hardness of the bonded interface between the ceramic member and the copper member bonded to each of one surface and the other surface of the ceramic member, it is possible to suppress the occurrence of breakage in the ceramic member during loading of a thermal cycle, and the thermal cycle reliability is excellent.

Here, in the copper/ceramic bonded body according to the present invention, it is preferable that a thickness ta1 of the active metal nitride layer formed on the side of the one surface of the ceramic member and a thickness ta2 of the active metal nitride layer formed on the side of the other surface of the ceramic member be set in a range of 0.05 µm or more and 0.8 µm or less, and a thickness ratio ta1/ta2 be set in a range of 0.7 or more and 1.4 or less.

In this case, since the thickness ta1 of the active metal nitride layer formed on the side of the one surface of the ceramic member and the thickness ta2 of the active metal nitride layer formed on the side of the other surface of the ceramic member are set in a range of 0.05 µm or more and 0.8 µm or less, the active metal reliably and firmly bonds the ceramic member and the copper member, and concurrently, the hardening of the bonded interface is suppressed.

In addition, since the thickness ratio ta1/ta2 is set in a range of 0.7 or more and 1.4 or less, there is no significant difference in the hardness of the bonded interface between the ceramic member and the copper member bonded to each of one surface and the other surface of the ceramic member, and the occurrence of breakage in the ceramic member during loading of a thermal cycle can be further suppressed.

In addition, in the copper/ceramic bonded body according to the present invention, it is preferable that at a bonded interface between the ceramic member and the copper member, an Ag-Cu alloy layer be formed on the side of the copper member, and a ratio tb1/tb2 of a thickness tb1 of the Ag-Cu alloy layer formed on the side of the one surface of the ceramic member to a thickness tb2 of the Ag-Cu alloy layer formed on the side of the other surface of the ceramic member be set in a range of 0.7 or more and 1.4 or less.

In this case, since the ratio tb1/tb2 of the thickness tb1 of the Ag-Cu alloy layer formed on the side of the one surface of the ceramic member to the thickness tb2 of the Ag-Cu alloy layer formed on the side of the other surface of the ceramic member is set in a range of 0.7 or more and 1.4 or less, there is no significant difference in the hardness of the bonded interface between the ceramic member and the copper member bonded to each of one surface and the other surface of the ceramic member, and the occurrence of breakage in the ceramic member during loading of a thermal cycle can be further suppressed.

The insulating circuit substrate according to the present invention is characterized by being an insulating circuit substrate including a ceramic substrate and a copper sheet consisting of copper or a copper alloy, which is bonded to a surface of the ceramic substrate, in which the copper sheet is bonded to each of one surface and the other surface of the ceramic substrate, an active metal nitride layer is formed on a side of the ceramic substrate of the copper sheet, where in a region of 10 µm from the active metal nitride layer to a side of the copper sheet, an area rate of an active metal compound containing Si and an active metal is set to 10% or less, and a ratio A1/A2 of an area rate A1 of the active metal compound in the copper sheet bonded to a side of the one surface to an area rate A2 of the active metal compound in the copper sheet bonded to a side of the other surface is set in a range of 0.7 or more and 1.4 or less.

According to the insulating circuit substrate according to the present invention, at the bonded interface between the ceramic substrate and the copper sheet bonded to each of one surface and the other surface of the ceramic substrate, an area rate of an active metal compound containing Si and an active metal is set to 10% or less in a region of 10 µm from the active metal nitride layer to a side of the copper sheet, which suppresses the unnecessary hardening of the bonded interface between the ceramic substrate and the copper sheet.

In addition, since the ratio A1/A2 of the area rate A1 of the active metal compound in the copper sheet bonded to a side of the one surface to the area rate A2 of the active metal compound in the copper sheet bonded to a side of the other surface is set in a range of 0.7 or more and 1.4 or less, there is no significant difference in the hardness of the bonded interface between the ceramic substrate and the copper sheet bonded to each of one surface and the other surface of the ceramic substrate, the occurrence of breakage in the ceramic substrate during loading of a thermal cycle can be suppressed, and the thermal cycle reliability is excellent.

Here, in the insulating circuit substrate according to the present invention, it is preferable that the thickness ta1 of the active metal nitride layer formed on the side of the one surface of the ceramic substrate and the thickness ta2 of the active metal nitride layer formed on the side of the other surface of the ceramic substrate be set in a range of 0.05 µm or more and 0.8 µm or less, and the thickness ratio tal/ta2 be set in a range of 0.7 or more and 1.4 or less.

In this case, since the thickness ta1 of the active metal nitride layer formed on the side of the one surface of the ceramic substrate to the thickness ta2 of the active metal nitride layer formed on the side of the other surface of the ceramic substrate is set in a range of 0.05 µm or more and 0.8 µm or less, the active metal reliably and firmly bonds the ceramic substrate and the copper sheet, and concurrently, the hardening of the bonded interface is suppressed.

In addition, since the thickness ratio ta1/ta2 is set in a range of 0.7 or more and 1.4 or less, there is no significant difference in the hardness of the bonded interface between the ceramic substrate and the copper sheet bonded to each of one surface and the other surface of the ceramic substrate, and the occurrence of breakage in the ceramic substrate during loading of a thermal cycle can be further suppressed.

In addition, in the insulating circuit substrate according to the present invention, it is preferable that at a bonded interface between the ceramic substrate and the copper sheet, the Ag-Cu alloy layer be formed on the side of the copper sheet, and the ratio tb1/tb2 of the thickness tb1 of the Ag-Cu alloy layer formed on the side of the one surface of the ceramic member to the thickness tb2 of the Ag-Cu alloy layer formed on the side of the other surface of the ceramic member be set in a range of 0.7 or more and 1.4 or less.

In this case, since the ratio tb1/tb2 of the thickness tb1 of the Ag-Cu alloy layer formed on the side of the one surface of the ceramic substrate to the thickness tb2 of the Ag-Cu alloy layer formed on the side of the other surface of the ceramic substrate is set in a range of 0.7 or more and 1.4 or less, there is no significant difference in the hardness of the bonded interface between the ceramic substrate and the copper sheet bonded to each of one surface and the other surface of the ceramic substrate, and the occurrence of breakage in the ceramic substrate during loading of a thermal cycle can be further suppressed.

### ADVANTAGEOUS EFFECTS OF INVENTION

According to the present invention, it is possible to provide a copper/ceramic bonded body having excellent thermal cycle reliability which can suppress the occurrence of breakage in a ceramic member even in a case where a severe thermal cycle is loaded, and an insulating circuit substrate consisting of the copper/ceramic bonded body.

### BRIEF DESCRIPTION OF DRAWINGS

FIG. 1 is a schematic explanatory view of a power module using an insulating circuit substrate according to an embodiment of the present invention.
FIG. 2A is an enlarged explanatory view of a bonded interface between a circuit layer and a ceramic substrate of the insulating circuit substrate according to the embodiment of the present invention.
FIG. 2B is an enlarged explanatory view of a bonded interface between a metal layer and a ceramic substrate of the insulating circuit substrate according to the embodiment of the present invention.
FIG. 3 is a flow chart of a manufacturing method for the insulating circuit substrate according to the embodiment of the present invention.
FIG. 4 is a schematic explanatory view of the manufacturing method for the insulating circuit substrate according to the embodiment of the present invention.
FIG. 5 is an explanatory view showing a calculation method for an area rate of an active metal compound in Example of the present invention.

### DESCRIPTION OF EMBODIMENTS

Hereinafter, embodiments of the present invention will be described with reference to the accompanying drawings.

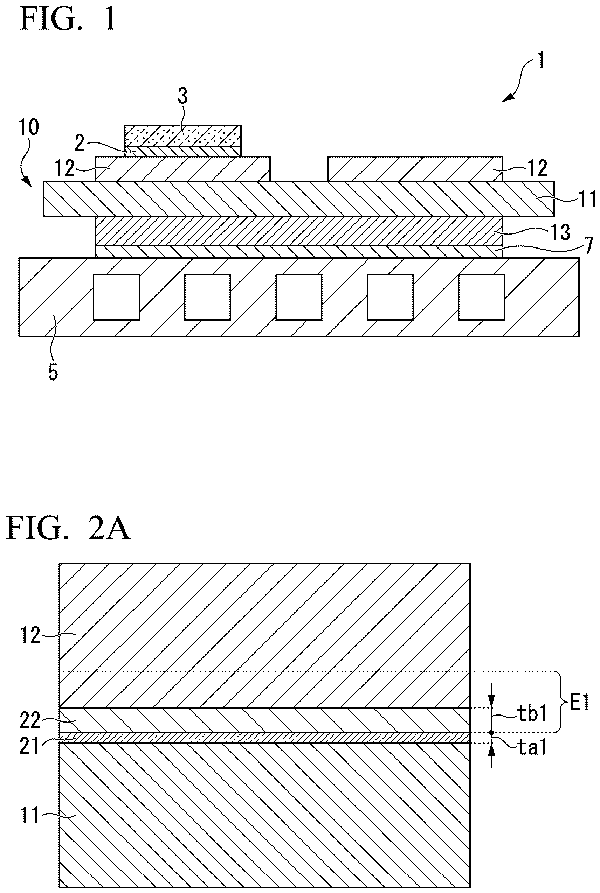

The copper/ceramic bonded body according to the present embodiment is an insulating circuit substrate 10 obtained by bonding a ceramic substrate 11 as a ceramic member consisting of ceramics to a copper sheet 42 (a circuit layer 12) as a copper member consisting of copper or a copper alloy and a copper sheet 43 (a metal layer 13). FIG. 1 shows a power module 1 including the insulating circuit substrate 10 according to the present embodiment.

The power module 1 includes the insulating circuit substrate 10 on which the circuit layer 12 and the metal layer 13 are arranged; a semiconductor element 3 bonded to one surface (the upper surface in FIG. 1) of the circuit layer 12 by interposing a bonding layer 2; and a heat sink 5 disposed on the other side (the lower side in FIG. 1) of the metal layer 13.

The semiconductor element 3 is composed of a semiconductor material such as Si. The semiconductor element 3 and the circuit layer 12 are bonded with the bonding layer 2 being interposed therebetween.

The bonding layer 2 is composed of, for example, an Sn-Ag-based solder material, an Sn-In-based solder material, or an Sn-Ag-Cu-based solder material.

The heat sink 5 is a heat sink for dissipating heat from the insulating circuit substrate 10 described above. The heat sink 5 is composed of copper or a copper alloy, and in the present embodiment, it is composed of phosphorus deoxidized copper. The heat sink 5 includes a passage for allowing a cooling fluid to flow.

It is noted that in the present embodiment, the heat sink 5 is bonded to the metal layer 13 by a solder layer 7 which consists of a solder material. The solder layer 7 is composed of, for example, an Sn-Ag-based solder material, an Sn-In-based solder material, or an Sn-Ag-Cu-based solder material.

In addition, the insulating circuit substrate 10 of the present embodiment includes, as shown in FIG. 1, the ceramic substrate 11, the circuit layer 12 arranged on one surface of the ceramic substrate 11 (the upper surface in Fig. 1), and the metal layer 13 arranged on the other surface of the ceramic substrate 11 (the lower surface in Fig. 1).

The ceramic substrate 11 is composed of silicon nitride (Si₃N₄), which has excellent insulating properties and heat radiation. The thickness of the ceramic substrate 11 is set, for example, in a range of 0.2 mm or more and 1.5 mm or less, and in the present embodiment, the thickness thereof is set to 0.32 mm.

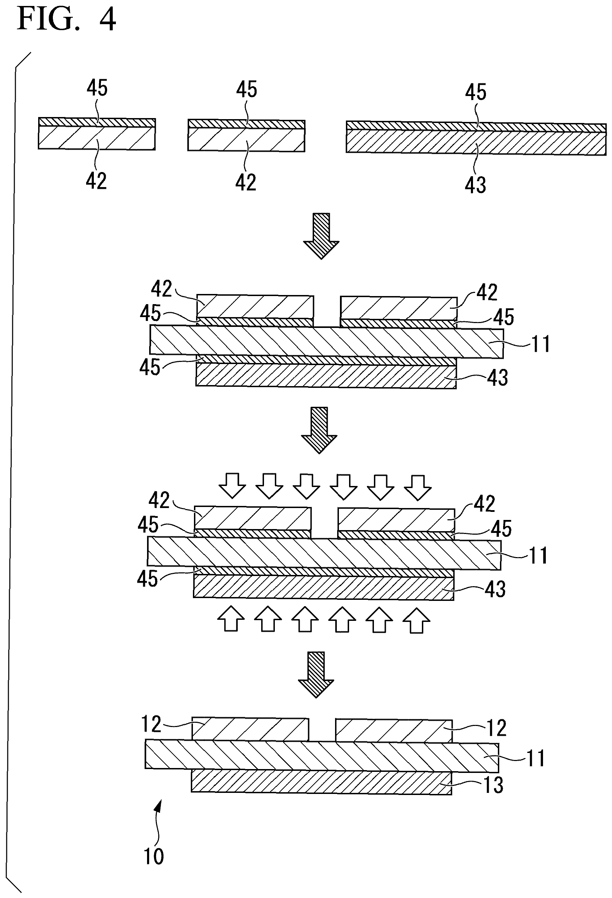

As shown in FIG. 4, the circuit layer 12 is formed by bonding the copper sheet 42 consisting of copper or a copper alloy to one surface (the upper surface in FIG. 4) of the ceramic substrate 11.

In the present embodiment, the circuit layer 12 is formed by bonding a punched rolled plate of oxygen-free copper to the ceramic substrate 11 in a state where the punched rolled plated is disposed in a circuit pattern.

It is noted that the thickness of the copper sheet 42 which is to be the circuit layer 12 is set in a range of 0.1 mm or more and 2.0 mm or less, and in the present embodiment, the thickness is set to 0.6 mm.

As shown in FIG. 4, the metal layer 13 is formed by bonding the copper sheet 43 consisting of copper or a copper alloy to the other surface (the lower surface in FIG. 4) of the ceramic substrate 11.

In the present embodiment, the metal layer 13 is formed by bonding a rolled plate of oxygen-free copper to the ceramic substrate 11.

It is noted that the thickness of the copper sheet 43 which is to be the metal layer 13 is set in a range of 0.1 mm or more and 2.0 mm or less, and in the present embodiment, the thickness is set to 0.6 mm.

At the bonded interface between the ceramic substrate 11 and the circuit layer 12, as shown in FIG. 2A, an active metal nitride layer 21 and an Ag-Cu alloy layer 22 are formed in this order from the ceramic substrate 11 side.

In addition, an area rate A1 of an active metal compound containing Si and an active metal (Ti in the present embodiment) is set to 10% or less in a region E1 of 10 µm from the interface of the active metal nitride layer 21 on the circuit layer 12 side (the interface between the active metal nitride layer 21 and the Ag-Cu alloy layer 22) to the circuit layer 12 side. The lower limit of the area rate A1 is not limited; however, it is set to, for example, 1%. Examples of the intermetallic compound containing Si and an active metal (Ti) include TiSi₂, TiSi, Ti₅Si₄, Ti₅Si₃, and Ti₅Si, and in the present embodiment, Ti₅Si₃ is adopted.

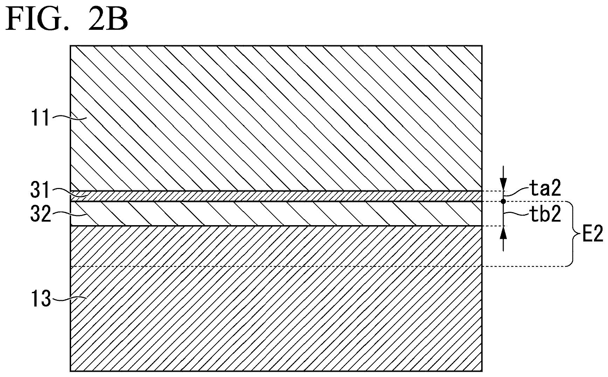

At the bonded interface between the ceramic substrate 11 and the metal layer 13, as shown in FIG. 2B, an active metal nitride layer 31 and an Ag-Cu alloy layer 32 are formed in this order from the ceramic substrate 11 side.

In addition, in a region E2 of 10 µm from the interface of the active metal nitride layer 31 on the metal layer 13 side (the interface between the active metal nitride layer 31 and the Ag-Cu alloy layer 32) to the metal layer 13 side, an area rate A2 of an active metal compound containing Si and an active metal (Ti in the present embodiment) is set to 10% or less. The lower limit of the area rate A2 is not limited; however, it is set to, for example, 1%. Examples of the intermetallic compound containing Si and an active metal (Ti) include TiSi₂, TiSi, Ti₅Si₄, Ti₅Si₃, and Ti₅Si, and in the present embodiment, Ti₅Si₃ is adopted.

In addition, in the present embodiment, the ratio A1/A2 of the area rate A1 of the active metal compound in the circuit layer 12 formed on one surface of the ceramic substrate 11 to the area rate A2 of the active metal compound in the metal layer 13 formed on the other surface of the ceramic substrate 11 is set in a range of 0.7 or more and 1.4 or less.

In addition, in the present embodiment, it is preferable that the thickness ta1 of the active metal nitride layer 21 formed on the side of the one surface of the ceramic substrate 11 to the thickness ta2 of the active metal nitride layer 31 formed on the side of the other surface of the ceramic substrate 11 be set in a range of 0.05 µm or more and 0.8 µm or less, and the thickness ratio ta1/ta2 be set in a range of 0.7 or more and 1.4 or less.

It is noted that in the present embodiment, since a bonding material 45 contains Ti as an active metal and the ceramic substrate 11 is composed of aluminum nitride, the active metal nitride layers 21 and 31 are composed of titanium nitride (TiN).

Further, in the present embodiment, it is preferable that the ratio tb1/tb2 of the thickness tb1 of the Ag-Cu alloy layer 22 formed on the side of the one surface of the ceramic substrate 11 to the thickness tb2 of the Ag-Cu alloy layer 32 formed on the side of the other surface of the ceramic substrate 11 be set in a range of 0.7 or more and 1.4 or less.

In addition, the thickness of the Ag-Cu alloy layer 22 (the Ag-Cu alloy layer 32) is preferably set to 1 µm or more and 30 µm or less.

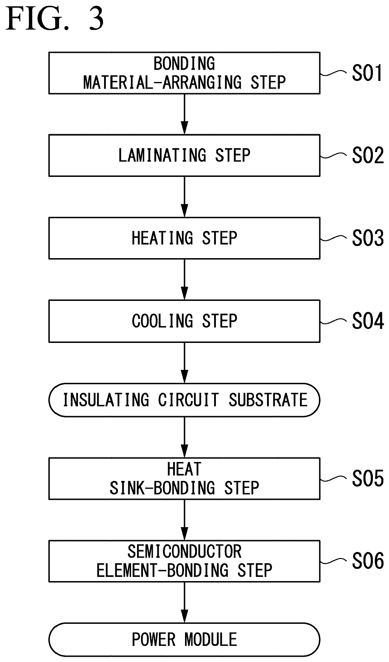

Hereinafter, a manufacturing method for the insulating circuit substrate 10 according to the present embodiment will be described with reference to FIG. 3 and FIG 4.

### (Bonding material-arranging step S01)

The copper sheet 42 which is to be the circuit layer 12 and the copper sheet 43 which is to be the metal layer 13 are prepared.

Here, the copper sheet 42 which is to be the circuit layer 12 is a press piece arranged in a circuit pattern.

Then, the bonding material 45 is applied and dried on the bonding surface of the copper sheet 42 which is to be the circuit layer 12 and the bonding surface of the copper sheet 43 which is to be the metal layer 13. The coating thickness of the paste-like bonding material 45 is preferably set in a range of 10 µm or more and 50 µm or less after drying.

In the present embodiment, the paste-like bonding material 45 is applied by screen printing.

The bonding material 45 is a bonding material containing Ag and an active metal (Ti, Zr, Nb, or Hf). In the present embodiment, an Ag-Ti-based brazing material (an Ag-Cu-Ti-based brazing material) is used as the bonding material 45. As the Ag-Ti-based brazing material (the Ag-Cu-Ti-based brazing material), it is preferable to use, for example, a brazing material which contains Cu in a range of 0 mass% or more and 32 mass% or less, contains Ti, which is an active metal, in a range of 0.5 mass% or more and 20 mass% or less, and has a balance of Ag and inevitable impurities.

Here, in a case of adjusting the specific surface area (BET value) of the Ag powder contained in the paste-like bonding material 45, the area rates A1 and A2 of the active metal compound containing Si and an active metal are controlled in the regions E1 and E2 of 10 µm from the interfaces of the active metal nitride layers 21 and 31 on the circuit layer 12 side and the metal layer 13 side to the circuit layer 12 side and the metal layer 13.

That is, in a case where the specific surface area of the Ag powder is small, the sinterability of the paste-like bonding material 45 increases, a liquid phase is easily generated in the heating step S03 described later, the diffusion of the active metal is accelerated, and the area rate of the active metal compound described above becomes high. On the other hand, in a case where the specific surface area of the Ag powder is large, the sinterability of the paste-like bonding material 45 decreases, it is difficult to generate a liquid phase in the heating step S03 described later, the diffusion of the active metal is suppressed, and the area rate of the active metal compound described above becomes low.

The specific surface area of the Ag powder is preferably set to 0.15 m²/g or more, more preferably set to 0.25 m²/g or more, and still more preferably set to 0.40 m²/g or more. On the other hand, the specific surface area of the Ag powder is preferably set to 1.40 m²/g or less, more preferably set to 1.00 m²/g or less, and still more preferably set to 0.75 m²/g or less.

Regarding the particle diameter of the Ag powder contained in the paste-like bonding material 45, it is preferable that D10 be set in a range of 0.7 µm or more and 3.5 µm or less, and D100 be set to 4.5 µm or more and 23 µm or less.

### (Laminating step S02)

Next, the copper sheet 42 which is to be the circuit layer 12 is laminated on one surface (the upper surface in FIG. 4) of the ceramic substrate 11 by interposing the bonding material 45, and concurrently, the copper sheet 43 which is to be the metal layer 13 is laminated on the other surface (the lower surface in FIG. 4) of the ceramic substrate 11 by interposing the bonding material 45.

### (Heating step S03)

Next, the copper sheet 42, the ceramic substrate 11, and the copper sheet 43 are heated in a pressurized state in a heating furnace in a vacuum atmosphere, and the bonding material 45 is melted. The term "pressurized state" here means, for example, a state in which the copper sheets 42 and 43 are pressed toward the ceramic substrate 11 side.

Here, the heating temperature in the heating step S03 is preferably set in a range of 800°C or higher and 850°C or lower. In addition, it is preferable that the total of the integrated temperature values in the temperature raising step from 780°C to the heating temperature and the holding step at the heating temperature be set in a range of 7°C h or more and 120°C·h or less.

In addition, the pressurization load in the heating step S03 is preferably set in a range of 0.029 MPa or more and 2.94 MPa or less.

Further, the degree of vacuum in the heating step S03 is preferably set in a range of 1 × 10⁻⁶ Pa or more and 5 × 10⁻² Pa or less.

### (Cooling step S04)

Then, after the heating step S03, cooling is carried out to solidify the molten bonding material 45, whereby the copper sheet 42 which is to be the circuit layer 12 is bonded to the ceramic substrate 11, and the ceramic substrate 11 is bonded to the copper sheet 43 which is to be the metal layer 13.

It is noted that the cooling rate in the cooling step S04 is preferably set in a range of 2°C/min or more and 20°C/min or less. It is noted that the cooling rate here is a cooling rate from the heating temperature to 780°C, which is an Ag-Cu eutectic temperature.

Here, in a case of adjusting the cooling rate on the circuit layer 12 (copper sheet 42) side and the metal layer 13 (copper sheet 43) side, the area rates A1 and A2 of the active metal compound containing Si and an active metal are controlled in the regions E1 and E2 of 10 µm from the interfaces of the active metal nitride layers 21 and 31 on the circuit layer 12 side and the metal layer 13 side to the circuit layer 12 side and the metal layer 13.

That is, in a case where the cooling rate is high, the diffusion of the active metal stops at an early stage, and the area rate of the active metal compound described above decreases. On the other hand, in a case where the cooling rate is slow, the diffusion of the active metal continues for a long period of time, and the area rate of the active metal compound described above increases.

It is noted that in the cooling step S04, in a case of allowing an inert gas to flow to any one of the circuit layer 12 (copper sheet 42) side or the metal layer 13 (copper sheet 43) side, it is possible to adjust the cooling rate on the circuit layer 12 (copper sheet 42) side and the metal layer 13 (copper sheet 43) side.

In addition, in a case where a spark plasma sintering (SPS) method is applied in the heating step S03 and the cooling step S04, it is possible to adjust the cooling rate on the circuit layer 12 (copper sheet 42) side and the metal layer 13 (copper sheet 43) side in a case of adjusting the flow rate of the cooling water at the electrode on the circuit layer 12 (copper sheet 42) side and the electrode on the metal layer 13 (copper sheet 43) side.

As described above, the insulating circuit substrate 10 of the present embodiment is manufactured by the bonding material-arranging step S01, the laminating step S02, the heating step S03, and the cooling step S04.

### (Heat sink-bonding step S05)

Next, the heat sink 5 is bonded to the other surface side of the metal layer 13 of the insulating circuit substrate 10.

The insulating circuit substrate 10 and the heat sink 5 are laminated with a solder material being interposed therebetween and charged into a heating furnace, and the insulating circuit substrate 10 and the heat sink 5 are subjected to solder bonding with the solder layer 7 being interposed therebetween.

### (Semiconductor element-bonding step S06)

Next, the semiconductor element 3 is bonded by soldering to one surface of the circuit layer 12 of the insulating circuit substrate 10.

The power module 1 shown in FIG. 1 is produced by the above-described steps.

According to the insulating circuit substrate 10 (copper/ceramic bonded body) of the present embodiment which has the above-described configuration, at the bonded interface between the circuit layer 12 formed on one surface of the ceramic substrate 11 and the metal layer 13 formed on the other surface thereof, the area rates A1 and A2 of the active metal compound containing Si and an active metal are set in a range of 10% or less in the regions E1 and E2 of 10 µm from the interfaces of the active metal nitride layers 21 and 31 on the circuit layer 12 side and the metal layer 13 side to the circuit layer 12 side and the metal layer 13, which suppresses the unnecessary hardening of the bonded interface between the ceramic substrate 11 and the circuit layer 12 and the bonded interface between the ceramic substrate 11 and the metal layer 13.

It is noted that in order to further suppress the unnecessary hardening of the bonded interface between the ceramic substrate 11 and the circuit layer 12 and the bonded interface between the ceramic substrate 11 and the metal layer 13, the area rates A1 and A2 of the active metal compound described above are preferably set to 8% or less and preferably set to 5% or less.

In addition, since the ratio A1/A2 of the area rate A1 of the active metal compound in the circuit layer 12 formed on one surface side of the ceramic substrate 11 to the area rate A2 of the active metal compound in the metal layer 13 bonded on the other surface side of the ceramic substrate 11 is set in a range of 0.7 or more and 1.4 or less, there is no significant difference in the hardness of the bonded interface between the circuit layer 12 formed on one surface of the ceramic substrate and the metal layer 13 formed on the other surface thereof, it is possible to suppress the occurrence of breakage in the ceramic substrate 11 during loading of a thermal cycle, and it is possible to improve the thermal cycle reliability.

It is noted that in order to further suppress the occurrence of breakage of the ceramic substrate 11 during loading of a thermal cycle, the ratio A1/A2 of the area rate A1 of the active metal compound in the circuit layer 12 formed on one surface side of the ceramic substrate 11 to the area rate A2 of the active metal compound in the metal layer 13 bonded on the other surface side of the ceramic substrate 11 is preferably set in a range of 0.8 or more and 1.2 or less and more preferably set in a range of 0.9 or more and 1.1 or less.

In addition, in the present embodiment, in a case where the thickness ta1 of the active metal nitride layer 21 formed on the side of the circuit layer 12 formed on one surface of the ceramic substrate 11 and the thickness ta2 of the active metal nitride layer 31 formed on the side of the metal layer 13 formed on the other surface of the ceramic substrate 11 are set to 0.05 µm or more, the active metal of the bonding material 45 sufficiently reacts with the ceramic substrate 11, and the ceramic substrate 11 is more firmly bonded to the circuit layer 12 and the metal layer 13.

On the other hand, in a case where the thickness ta1 of the active metal nitride layer 21 and the thickness ta2 of the active metal nitride layer 31 are set to 0.8 µm or less, it is possible to suppress the unnecessary hardening of the bonded interface, and it is possible to further improve the thermal cycle reliability.

It is noted that in order to more firmly bond the ceramic substrate 11 to the circuit layer 12 and the metal layer 13, the thickness ta1 of the active metal nitride layer 21 and the thickness ta2 of the active metal nitride layer 31 are preferably set to 0.08 µm or more and more preferably set to 0.15 µm or more.

In addition, in order to further suppress the unnecessary hardening of the bonded interface, the thickness ta1 of the active metal nitride layer 21 and the thickness ta2 of the active metal nitride layer 31 are preferably set to 0.6 µm or less and more preferably set to 0.4 µm or less.

Further, in the present embodiment, in a case where the thickness ratio ta1/ta2 of the thickness ta1 of the active metal nitride layer 21 to the thickness ta2 of the active metal nitride layer 31 is set in a range of 0.7 or more and 1.4 or less, there is no significant difference in the hardness of the bonded interface between the circuit layer 12 formed on one surface of the ceramic substrate 11 and the metal layer 13 formed on the other surface the ceramic substrate 11, and it is possible to further suppress the occurrence of breakage in the ceramic substrate 11 during loading of a thermal cycle.

It is noted that in order to further suppress the occurrence of breakage in the ceramic substrate 11 during loading of a thermal cycle, the thickness ratio ta1/ta2 of the thickness ta1 of the active metal nitride layer 21 to the thickness ta2 of the active metal nitride layer 31 is preferably set in a range of 0.8 or more and 1.2 or less and more preferably set in a range of 0.9 or more and 1.1 or less.

In addition, in the present embodiment, in a case where the ratio tb1/tb2 of the thickness tb1 of the Ag-Cu alloy layer 22 formed on the side of the one surface of the ceramic substrate 11 to the thickness tb2 of the Ag-Cu alloy layer 32 formed on the side of the other surface of the ceramic substrate 11 is set in a range of 0.7 or more and 1.4 or less, there is no significant difference in the hardness of the bonded interface between the circuit layer 12 formed on one surface of the ceramic substrate 11 and the metal layer 13 formed on the other surface the ceramic substrate 11, and it is possible to further suppress the occurrence of breakage in the ceramic substrate 11 during loading of a thermal cycle.

It is noted that in order to further suppress the occurrence of breakage in the ceramic substrate 11 during loading of a thermal cycle, the thickness ratio tb1/tb2 of the thickness tb1 of the Ag-Cu alloy layer 22 to the thickness tb2 of the Ag-Cu alloy layer 32 is preferably set in a range of 0.8 or more and 1.2 or less and more preferably set in a range of 0.9 or more and 1.1 or less.

The embodiment of the present invention has been described above. However, the present invention is not limited thereto and can be appropriately modified without departing from the technical idea of the invention.

For example, the present embodiment has been described such that a semiconductor element is mounted on an insulating circuit substrate to constitute a power module; however, the present embodiment is not limited thereto.

For example, an LED element may be mounted on a circuit layer of an insulating circuit substrate to constitute an LED module, or a thermoelectric element may be mounted on a circuit layer of an insulating circuit substrate to constitute a thermoelectric module.

Further, in the present embodiment, the description has been made using Ti as an example of the active metal contained in the bonding material. However, the present embodiment is not limited thereto, and any one or two or more active metals selected from Ti, Zr, Hf, and Nb may be contained. It is noted that these active metals may be contained as hydrides.

### [Examples]

Hereinafter, a description will be given of the results of confirmatory experiments carried out to confirm the effectiveness of the present invention.

First, a ceramic substrate (40 mm × 40 mm, thickness: 0.32 mm) consisting of silicon nitride ((Si₃N₄) was prepared.

In addition, as the copper sheet which is to be a circuit layer, two copper pieces consisting of oxygen-free copper and having a size of 37 mm × 18 mm and a thickness of 0.8 mm were prepared. Further, as the copper sheet which is to be a metal layer, a copper sheet consisting of oxygen-free copper and having a size of 37 mm × 37 mm and a thickness of 0.8 mm was prepared.

A bonding material containing an Ag powder having a BET value shown in Table 1 was applied onto the copper sheet which is to be a circuit layer so that the target thickness after drying was 30 µm.

A bonding material containing an Ag powder having a BET value shown in Table 1 was applied onto the copper sheet which is to be a metal layer so that the target thickness after drying was 30 µm.

It is noted that a paste material was used as the bonding material, and the amounts of Ag, Cu, and the active metal were as shown in Table 1.

In addition, vacuum degassing was carried out as a pretreatment by heating at 150°C for 30 minutes, and the BET value (specific surface area) of the Ag powder was measured using AUTOSORB-1 manufactured by QUANTACHRROME Corporation by a BET multipoint method under the conditions of N₂ adsorption and liquid nitrogen of 77 K.

A copper sheet which is to be a circuit layer was laminated on one surface of the ceramic substrate. In this case, two copper pieces were disposed to have a spacing of 1 mm.

In addition, a copper sheet which is to be a metal layer was laminated on the other surface of the ceramic substrate.

This laminate was heated in a state of being pressurized in the lamination direction to melt the bonding material. In this case, the pressurization load was set to 0.245 MPa, and the integrated temperature value was as shown in Table 1.

Then, the heated laminate was cooled to bond the copper sheet which is to be the circuit layer, the ceramic substrate, and the metal plate which is to be the metal layer to each other, thereby obtaining an insulating circuit substrate (copper/ceramic bonded body).

It is noted that in Examples, the bonding was carried out according to the spark plasma sintering (SPS) method, and the flow rate of the cooling water was adjusted at the electrode on the circuit layer side and the electrode on the metal layer side, thereby being adjusted to be the cooling rate shown in Table 1.

Regarding the obtained insulating circuit substrate (copper/ceramic bonded body), the area rate of the active metal compound, the active metal nitride layer, the Ag-Cu alloy layer, and the thermal cycle reliability were evaluated as follows.

### (Area rate of active metal compound)

Cross sections of the bonded interface between the circuit layer and the ceramic substrate and the bonded interface between the ceramic substrate and the metal layer were observed with an EPMA device, and an element map (width 50 µm × height 30 µm) of the active metal and Si in the circuit layer and the metal layer was acquired for each of five visual fields.

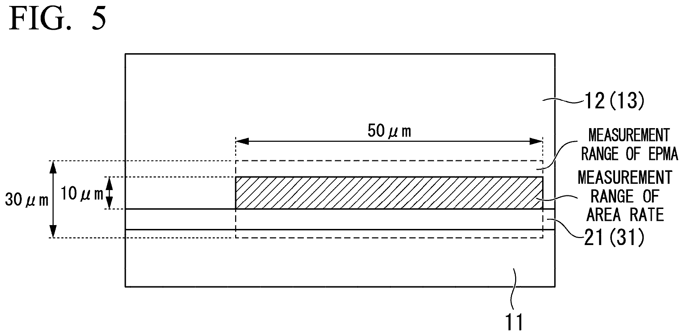

Then, as shown in FIG. 5, in a region from the active metal nitride layer to 10 µm toward the circuit layer (metal layer) surface, a portion where Si and the active metal overlapped was regarded as an area of active metal compound containing Si and the active metal, and the area rate of the active metal compound was calculated. The area rate is a value in a case where an area of 50 µm × 10 µm is set to 100%. It is noted that Table 2 shows the average values from each of the five visual fields.

### (Active metal nitride layer)

Cross sections of the bonded interface between the circuit layer and the ceramic substrate and the bonded interface between the ceramic substrate and the metal layer were subjected to measurement at a magnification of 30,000 times using an electron scanning microscope (ULTRA55 manufactured by Carl Zeiss NTS, LLC, acceleration voltage: 1.8 kV), and an element map of N, O, and the active metal element was acquired according to the energy dispersive X-ray analysis method. It was determined that the active metal nitride layer was present in a case where the active metal element and N or O were present in the same region.

The observation was carried out in each of five visual fields, and the average value obtained by dividing the area in the range in which the active metal element and N or O were present in the same region by the measured width was defined as the "thickness of the active metal nitride layer".

### (Ag-Cu alloy layer)

Cross sections of the bonded interface between the circuit layer and the ceramic substrate and the bonded interface between the ceramic substrate and the metal layer were subjected to line analysis in each of five visual fields by using an EPMA device.

Then, in a case where Ag + Cu + active metal was set to 100% by mass, a region in which the Ag concentration was 15% by mass or more was defined as the Ag-Cu alloy layer, and the thickness thereof was measured. The average of the measured values in each of the five visual fields is shown in Table 2 as the thickness of the Ag-Cu alloy layer.

### (Thermal cycle reliability)

The above-described insulating circuit substrate was loaded with thermal cycles in which 40°C × 5min and 150°C × 5min were alternately repeated, an SAT examination was carried out every 100 cycles up to 2,000 cycles to check for the presence or absence of ceramic breakage, and the number of times of occurrence of ceramic breakage was evaluated. The evaluation results are shown in Table 2. Here, the term "the number of times of occurrence of ceramic breakage" means the number of thermal cycles required until ceramic breakage occurred.

**[Table 1]**

| | | Bonding material on circuit layer side | | | | | Bonding material on metal layer side | | | | | Heating step | Cooline step | |
|---|---|---|---|---|---|---|---|---|---|---|---|---|---|---|
| | | Ag | Cu mass% | Active element | | BET value of Ag powder (m²/g) | Ag | Cu mass% | Active element | | BET value of Ag powder (m²/g) | Integrated temperature value °C·h | Circuit layer °C/min | Metal layer °C/min |
| | | | | N lemcntmass% | | | | | Element | mass% | | | | |
| Present Invention Example | 1 | Balance | - | Ti | 11.3 | 1.38 | Balance | - | Ti | 11.3 | 0.69 | 118.6 | 5 | 2 |
| | 2 | Balance | - | Ti | 4.8 | 0.16 | Balance | - | Ti | 4.8 | 1.38 | 76.0 | 12 | 18 |
| | 3 | Balance | - | Ti | 8.5 | 0.56 | Balance | - | Ti | 8.5 | 0.16 | 56.0 | 15 | 12 |
| | 4 | Balance | 24.5 | Ti | 5.5 | 0.69 | Balance | 24.5 | Ti | 5.5 | 1.03 | 78.2 | 15 | 18 |
| | 5 | Balance | - | Ti | 3.7 | 0.44 | Balance | - | Ti | 3.7 | 0.69 | 45.8 | 7 | 9 |
| | 6 | Balance | - | Zr | 4.9 | 0.44 | Balance | - | Zr | 4.9 | 0.56 | 25.9 | 7 | 12 |
| | 7 | Balance | 25.5 | Hf | 2.5 | 1.03 | Balance | 25.5 | Hf | 2.5 | 0.56 | 7.5 | 20 | 17 |
| | 8 | Balance | 25.5 | Nb | 2.5 | 0.69 | Balance | 25.5 | Nb | 2.5 | 0.44 | 14.3 | 15 | 12 |
| Comparative Example | 1 | Balance | - | Ti | 12.5 | 1.38 | Balance | - | Ti | 12.5 | 0.69 | 160.4 | 3 | 1 |
| | 2 | Balance | - | Zr | 6.5 | 0.16 | Balance | - | Zr | 6.5 | 1.38 | 54.2 | 5 | 15 |
| | 3 | Balance | 24.5 | Zr | 3.5 | 0.69 | Balance | 24.5 | Zr | 3.5 | 0.16 | 62.5 | 12 | 7 |

**[Table 2]**

| | | Active metal compound | | | Active metal nitride layer | | | Ag-Cu alloy layer | | | Thermal cycle reliability |
|---|---|---|---|---|---|---|---|---|---|---|---|
| | | Area rate (%) | | A1/A2 | Thickness (µm) | | ta1/ta2 | Thickness (µm) | | tb1/tb2 | |
| | | Circuit layer side A1 | Metal layer side A2 | | Circuit layer side ta1 | Metal layer side ta2 | | Circuit layer side tb1 | Metal layer side tb2 | | Number of times of occurrence of breakage (times) |
| Present Invention Example | 1 | 9.8 | 7.9 | 1.24 | 0.91 | 0.76 | 1.20 | 9 | 7 | 1.29 | 1500 |
| | 2 | 5.8 | 7.9 | 0.73 | 0.39 | 0.46 | 0.85 | 13 | 11 | 1.18 | 1600 |
| | 3 | 7.2 | 5.3 | 1.36 | 0.51 | 0.44 | 1.16 | 12 | 14 | 0.86 | 1600 |
| | 4 | 6.5 | 7.8 | 0.83 | 0.48 | 0.57 | 0.84 | 15 | 13 | 1.15 | 1800 |
| | 5 | 3.9 | 4.3 | 0.91 | 0.21 | 0.23 | 0.91 | 10 | 8 | 1.25 | 1900 |
| | 6 | 2.8 | 3.0 | 0.93 | 0.28 | 0.31 | 0.90 | 12 | 10 | 1.20 | >2000 |
| | 7 | 1.6 | 1.5 | 1.07 | 0.06 | 0.05 | 1.20 | 23 | 27 | 0.85 | 2000 |
| | 8 | 2.2 | 2.0 | 1.10 | 0.09 | 0.08 | 1.13 | 14 | 16 | 0.88 | 2000 |
| Comparative Example | 1 | 14.6 | 13.4 | 1.09 | 1.17 | 0.94 | 1.24 | 5 | 2 | 2.50 | 1100 |
| | 2 | 3.8 | 6.1 | 0.62 | 0.34 | 0.41 | 0.83 | 12 | 16 | 0.75 | 1200 |
| | 3 | 6.8 | 4.6 | 1.48 | 0.37 | 0.33 | 1.12 | 10 | 13 | 0.77 | 1200 |

In Comparative Example 1 in which the area rate A1 of the active metal compound on the circuit layer side was set to 14.6% and the area rate A2 of the active metal compound on the metal layer side was set to 13.4%, breakage was confirmed in 1,100 cycles, and thus the thermal cycle reliability was insufficient.

In Comparative Example 2 in which the ratio A1/A2 of the area rate A1 of the active metal compound on the circuit layer side to the area rate A2 of the active metal compound on the metal layer side was set to 0.62, breakage was confirmed in 1,200 cycles, and thus the thermal cycle reliability was insufficient.

In Comparative Example 3 in which the ratio A1/A2 of the area rate A1 of the active metal compound on the circuit layer side to the area rate A2 of the active metal compound on the metal layer side was set to 1.48, breakage was confirmed in 1,200 cycles, and thus the thermal cycle reliability was insufficient.

In contrast, in Present Invention Examples 1 to 8 in which the area rate A1 of the active metal compound on the circuit layer side and the area rate A2 of the active metal compound on the metal layer side were both set to 10% or less, and the ratio A1/A2 of the area rate A1 of the active metal compound on the circuit layer side to the area rate A2 of the active metal compound on the metal layer side was set in a range of 0.7 or more and 1.4 or less, the number of cycles at which breakage was confirmed was 1,500 or more, and thus the thermal cycle reliability was excellent.

As a result of the above-described experiments, according to the Present Invention Examples, it was confirmed that it is possible to provide an insulating circuit substrate (a copper/ceramic bonded body) having excellent thermal cycle reliability which can suppress the occurrence of breakage in a ceramic member even in a case where a severe thermal cycle is loaded.

### [Industrial Applicability]

According to the present invention, it is possible to provide a copper/ceramic bonded body having excellent thermal cycle reliability which can suppress the occurrence of breakage in a ceramic member even in a case where a severe thermal cycle is loaded, and an insulating circuit substrate consisting of the copper/ceramic bonded body.

### [Reference Signs List]

10: Insulating circuit substrate (copper/ceramic bonded body)
11: Ceramic substrate (ceramic member)
12: Circuit layer (copper member)
13: Metal layer (copper member)
21, 31: Active metal nitride layer
22, 32: Ag-Cu alloy layer

## Claims

1. A copper/ceramic bonded body, comprising:
a copper member consisting of copper or a copper alloy; and
a ceramic member consisting of silicon nitride, which is bonded to the copper member,
wherein the copper member is bonded to each of one surface and the other surface of the ceramic member,
an active metal nitride layer is formed on a side of the ceramic member of the copper member, where in a region of 10 µm from the active metal nitride layer to a side of the copper member, an area rate of an active metal compound containing Si and an active metal is set to 10% or less, and
a ratio A1/A2 of an area rate A1 of the active metal compound in the copper member bonded to a side of the one surface to an area rate A2 of the active metal compound in the copper member bonded to a side of the other surface is set in a range of 0.7 or more and 1.4 or less.

2. The copper/ceramic bonded body according to Claim 1,
wherein a thickness ta1 of the active metal nitride layer formed on the side of the one surface of the ceramic member and a thickness ta2 of the active metal nitride layer formed on the side of the other surface of the ceramic member are set in a range of 0.05 µm or more and 0.8 µm or less, and a thickness ratio ta1/ta2 is set in a range of 0.7 or more and 1.4 or less.

3. The copper/ceramic bonded body according to Claim 1 or 2,
wherein at a bonded interface between the ceramic member and the copper member, an Ag-Cu alloy layer is formed on the side of the copper member, and
a ratio tb1/tb2 of a thickness tb1 of the Ag-Cu alloy layer formed on the side of the one surface of the ceramic member to a thickness tb2 of the Ag-Cu alloy layer formed on the side of the other surface of the ceramic member is set in a range of 0.7 or more and 1.4 or less.

4. An insulating circuit substrate, comprising:
a ceramic substrate; and
a copper sheet consisting of copper or a copper alloy, which is bonded to a surface of the ceramic substrate,
wherein the copper sheet is bonded to each of one surface and the other surface of the ceramic substrate,
an active metal nitride layer is formed on a side of the ceramic substrate of the copper sheet, where in a region of 10 µm from the active metal nitride layer to a side of the copper sheet, an area rate of an active metal compound containing Si and an active metal is set to 10% or less, and
a ratio A1/A2 of an area rate A1 of the active metal compound in the copper sheet bonded to a side of the one surface to an area rate A2 of the active metal compound in the copper sheet bonded to a side of the other surface is set in a range of 0.7 or more and 1.4 or less.

5. The insulating circuit substrate according to Claim 4,
wherein a thickness ta1 of the active metal nitride layer formed on the side of the one surface of the ceramic substrate and a thickness ta2 of the active metal nitride layer formed on the side of the other surface of the ceramic substrate are set in a range of 0.05 µm or more and 0.8 µm or less, and a thickness ratio ta1/ta2 is set in a range of 0.7 or more and 1.4 or less.

6. The insulating circuit substrate according to Claim 4 or 5,
wherein at a bonded interface between the ceramic substrate and the copper sheet, an Ag-Cu alloy layer is formed on the side of the copper sheet, and
a ratio tb1/tb2 of a thickness tb1 of the Ag-Cu alloy layer formed on the side of the one surface of the ceramic substrate to a thickness tb2 of the Ag-Cu alloy layer formed on the side of the other surface of the ceramic substrate is set in a range of 0.7 or more and 1.4 or less.
